# EUROPEAN PATENT SPECIFICATION

(11) **EP 4 050 130 B1**
(45) Date of publication and mention of the grant of the patent: **31.12.2025**
(21) Application number: 20878216.9
(22) Date of filing: 25.10.2020
(51) Int. Cl.: C30B 7/10, C30B 29/20, B01J 20/08, B01J 20/28, B01J 20/30, B01J 21/04, B01J 23/62, B01J 23/883, B01J 23/888, B01J 37/00, B01J 37/02, B01J 37/10, C10G 45/08, B01J 37/18, B01J 37/20

(54) **ALUMINA GRAIN, PREPARATION METHOD THEREFOR AND USE THEREOF**
ALUMINIUMOXIDKORN, VERFAHREN ZU SEINER HERSTELLUNG UND SEINE VERWENDUNG
GRAIN D'ALUMINE, SON PROCÉDÉ DE PRÉPARATION ET UTILISATION ASSOCIÉE

(30) Priority: 25.10.2019 CN 201911020895
(43) Date of publication of application: 31.08.2022
(73) Proprietor: China Petroleum & Chemical Corporation, Beijing 100728 (CN); Dalian Research Institute Of Petroleum And Petrochemicals, Sinopec Corp., Dalian, Liaoning Province 116045 (CN)
(72) Inventor: YANG, Weiya, Dalian, Liaoning 116045 (CN); SUI, Baokuan, Dalian, Liaoning 116045 (CN); LING, Fengxiang, Dalian, Liaoning 116045 (CN); ZHANG, Huicheng, Dalian, Liaoning 116045 (CN); WANG, Shaojun, Dalian, Liaoning 116045 (CN); SHEN, Zhiqi, Dalian, Liaoning 116045 (CN)
(74) Representative: Hoffmann Eitle
(86) International application number: PCT/CN2020/123485
(87) International publication number: WO 2021/078292

(56) References cited:
- EP-A1- 1 193 232
- WO-A1-01/56926
- WO-A1-2018/044533
- CN-A- 1 095 360
- CN-A- 1 100 066
- CN-A- 102 311 132
- CN-A- 102 320 638
- CN-A- 107 304 059
- CN-A- 107 304 059
- CN-A- 107 540 006
- CN-A- 107 540 006
- US-A1- 2006 193 040

## Description

### FIELD

The present disclosure pertains to the technical field of inorganic material production, and specifically relates to an alumina grain and the preparation method and use thereof.

### BACKGROUND

Activated alumina has desirable physicochemical properties such as a large specific surface area, an adjustable pore structure, the presence of acid centers with different properties on the surface, high mechanical strength and thermal stability, thus it is widely used as a carrier material for heterogeneous catalysts. The physicochemical property of alumina is one of the key factors determining catalytic performance of the catalysts.

As a crystal material, different crystal planes of alumina have various atomic density and atomic symmetry, resulting in different electronic structure, surface energy, chemical activity and other property of the crystal planes. By adjusting and varying the growth environment of alumina grain, modifying the crystal plane type and the distribution ratio of crystal planes on the alumina grain surface, it is possible to perform a deep regulation and control from the source in regard to the critical physicochemical properties of alumina, such as specific surface, pore structure, acidity, atomic and/or molecular chemical environment. For example, the inventors of the present disclosure have disclosed the methods of preparing a flake polycrystalline γ-alumina, alumina hollow spheres assembled from the flake alumina, and alumina microspheres with a core-shell structure assembled from the flake alumina in their previously filed patent literatures CN106140180B, CN106673030B and CN106673033B.
CN107540006A describes a method for preparing octahedral alumina having a micron dimension. EP1193232A1 describes a process for preparing an alumina composition.

Currently, the industrial hydrogenation catalysts are supported on the carrier alumina (γ-alumina) having a surface dominated by the distribution of (110), (111) and (100) crystal planes, wherein the distribution of (110) crystal plane generally accounts for 50%-70%. Three crystal planes of the alumina surface and their distribution can significantly influence the activity phase of the hydrogenation catalyst, and may cause the catalysts to respectively exhibit distinctive catalytic properties, such as directionally enhanced hydrodesulfurization and olefin saturation property in the technical field of hydrogenation catalysis. Therefore, if the relative proportions of (110), (111) and (100) crystal planes of the alumina surface can be flexibly regulated and controlled such that the crystal planes respectively reach the advantageous distribution, and the law of an influence of the advantageous crystal planes on the catalytic properties of the hydrogenation catalyst is determined, it can provide a theoretical guide for the development of novel heterogeneous catalyst carriers and form the new technical routes for regulating and controlling the catalyst properties. However, because of the limitations and constraints on the growth habit of alumina grains, it is difficult to effectively change the advantageous distribution condition of the (110) crystal planes on the alumina surface through the conventional synthesis methods.

The regulation and control of the type and distribution of crystal planes on alumina surfaces remains a significant scientific challenge worldwide which urgently needs to be addressed.

### SUMMARY

An alumina grain, a preparation method and a use thereof according to the present invention are defined in the claims. The present disclosure provides an octahedral alumina crystal grain and a preparation method thereof. The alumina grain of the present disclosure, which is unique in crystal plane exposure, when it is used as a heterogeneous catalyst carrier, the catalyst provides significantly enhanced catalytic performance.

The alumina grain of the present disclosure has a single-crystal structure and a regular octahedral or an approximate regular octahedral morphology. The eight crystal planes exposed on the surface of the octahedral grain belong to the {111} family of crystal planes of γ-state alumina, the crystal planes are (111), (-111), (1-11), (11-1), (-1-1-1), (-11-1), and (-1-11) crystal planes, respectively; the eight crystal planes of the alumina grain each has an equilateral triangle or a near-equilateral triangle shape with a side length of 5-70µm. The alumina grain has a grain size within a range of 7-100µm.

The preparation method of alumina grain, the method comprises the following steps:
(1) subjecting the alumina powder having a certain particle size to a shear treatment in the presence of a solvent and a polymerization inhibitor to obtain a stable suspension;
(2) mixing the suspension obtained in step (1) with a crystal plane growth guiding agent uniformly and subjecting the mixture to a hydrothermal treatment under a hermetic conditions, then performing a solid-liquid separation, and subjecting the solid to drying and roasting.

The alumina crystal grain material provided by the present disclosure has a promising prospect in the technical fields of heterogeneous catalysis and adsorption, for example, in the aspects of being applied as a hydrogenation catalyst carrier for distillate oil, a hydrogenation demetallization catalyst carrier for residual oil, a propane dehydrogenation catalyst carrier to produce propylene. The preparation method provided by the present disclosure is simple and feasible, and has low costs and higher operability.

The scope of the present invention is defined as set forth in the appended claims.

### BRIEF DESCRIPTION OF THE DRAWINGS

FIG. 1 is a schematic diagram illustrating an octahedral grain surface exposed crystal plane of the cubic crystal system.
FIG. 2 illustrates a scanning electron microscope photograph of the alumina grain prepared in Example 1 after roasting at 550°C.
FIG. 3 illustrates an electron diffraction spectrum of the alumina grain prepared in Example 1 after roasting at 550°C.
FIG. 4 illustrates an XRD spectrogram of the alumina grain prepared in Example 1 after drying at 200°C.
FIG. 5 illustrates an XRD spectrogram of the alumina grain prepared in Example 1 after roasting at 550°C.
FIG. 6 illustrates an electron diffraction spectrum of the sample obtained in the Comparative Example 1 after roasting at 550°C.

### DETAILED DESCRIPTION

The terminals and any value of the ranges disclosed herein are not limited to the precise ranges or values, such ranges or values shall be comprehended as comprising the values adjacent to the ranges or values. As for numerical ranges, the endpoint values of the various ranges, the endpoint values and the individual point value of the various ranges, and the individual point values may be combined with one another to produce one or more new numerical ranges, which should be deemed have been specifically disclosed herein.

The alumina of the present disclosure is a grain having a single-crystal structure and a regular octahedral or an approximate regular octahedral stereoscopic morphology. The eight crystal planes on the surface of the octahedral grain of alumina belong to the {111} family of crystal planes of γ-state alumina, the crystal planes are (111), (-111), (1-11), (11-1), (-1-1-1), (-11-1), and (-1-11) crystal planes, respectively. Because the γ-alumina has a face-centered cubic crystal structure with high symmetry, the crystal planes have equivalent properties, thus the crystal planes are uniformly expressed by using the (111) crystal plane.

The eight crystal planes of the octahedral alumina grain surface each has a shape of an equilateral triangle or a near-equilateral triangle shape with a side length of 5-70µm.

The octahedral alumina grain provided by the present disclosure has a grain size of 7-100µm.

In the present disclosure, the shape and size of alumina grain are observed and measured through a scanning electron microscope. The crystal form is characterized by X-ray diffraction, and the sample particle is determined to be monocrystal or polycrystal through the electron diffraction analysis.

In the present disclosure, regular octahedra means that each of the eight crystal planes on the octahedral surfaces forms an equilateral triangle, and the side lengths of the eight equilateral triangles are equal. In the present disclosure, near-regular octahedra refers to that each of the eight crystal planes on the octahedral surfaces forms a triangle, and the side lengths of the eight triangles are approximately equal. The relative deviation of any side length of any one of the triangles as compared to an average of the total side lengths of the eight triangles falls into the range of ±10%.

The alumina grain of the present disclosure has a percentage of 90% or more, preferably 100% of the (111) crystal plane family surface, a percentage of 5% or less of the (100) crystal plane family surface, and a percentage of 10% or less of the (110) crystal plane family surface, based on a total surface of the (111) crystal plane family surface, the (110) crystal plane family surface and the (100) crystal plane family surface.

The percentage of surface area of crystal planes is determined by an area method, the percentage relationship of a crystal plane is obtained by dividing the area occupied by a crystal plane on an alumina grain surface by the total area of the crystal planes on the alumina grain surface. A scanning electron microscope is used for taking a photograph of the sample, the side length of a triangular crystal plane of an octahedral grain is measured from the photograph, then calculate the area of the triangle, the total area of the outer surface of the entire crystal grain can be calculated, such that the percentage of a specific crystal plane can be calculated based on the proportional relationship of areas.

The side length of 8 surfaces of the alumina grain is preferably within a range of 14-65µm.

The alumina grain has a grain size within a range of 7-100µm, preferably 10-91µm, such as 7µm, 8µm, 10µm, 15µm, 21µm, 25µm, 30µm, 35µm, 40µm, 45µm, 50µm, 55µm, 60µm, 65µm, 70µm, 75µm, 80µm, 85µm, 90µm and 95µm.

In the present disclosure, the size of alumina grain refers to the distance between two furthest vertices of the octahedral grain. The grain size can be measured directly from the scanning electron microscope.

According to a preferred embodiment of the present disclosure, the XRD spectrogram of the alumina grain provided by the present disclosure after roasting at 500-550°C illustrates that the characteristic diffraction peaks of γ-alumina corresponding to the (220), (311), (222), (400), (511) and (440) crystal planes are presented adjacent to positions of the diffraction angles of 33.53°, 36.82°, 39.49°, 46.38°, 60.89° and 67.01° respectively when the angle 2θ=10-70°. In the present disclosure, the numerical range of the diffraction angle 2θ is allowed to vary by ±1°.

In the method of the present disclosure, the alumina of step (1) has a particle size of 2,000-20,000 mesh, the alumina powder is obtained by grinding the commercially available alumina powder or initially roasting the pseudo-boehmite and then grinding the roasted pseudo-boehmite.

The conditions of roasting may comprise a temperature of 350-650°C, preferably 400-550°C, and a time of 1-12 hours, preferably 2-6 hours. In the present disclosure, 1,000 mesh or more refer to a sieve pore size corresponding to the particle size of the powder which is less than 1,000 mesh.

The grinding may be carried out by using a high energy ball mill, the operating conditions of which are flexibly adjusted in order to obtain a required particle size of the powder.

In the method of the present disclosure, in order to make the ball milling to be smooth, an inorganic lubricant is preferably added during the ball milling process, and the inorganic lubricant is removed after the grinding so as to perform the subsequent operation. The inorganic lubricant may be an inorganic sodium salt, and the inorganic sodium salt is preferably one or more selected from the group consisting of sodium nitrate, sodium chloride, sodium sulfate, sodium carbonate, sodium bicarbonate, sodium phosphate, sodium formate, sodium acetate and sodium citrate.

The inorganic sodium salt is used in an amount of 0.1-10wt%, preferably 2-5wt% of the alumina powder (based on the product obtained after roasting the pseudo-boehmite powder at 550°C for 5 hours).

In the present disclosure, the inorganic sodium salt is preferably removed by washing with water, preferably deionized water.

In the method of the present disclosure, the operation of step (1) is preferably carried out by initially mixing the solvent with alumina powder to form an alumina suspension, then adding a polymerization inhibitor and subjecting the suspension to a shear treatment to obtain a stable suspension. The alumina suspension has a mass concentration of 10-200g/L, preferably 15-100g/L, more preferably 20-50 g/L.

In the method of the present disclosure, the solvent (of the alumina suspension) in step (1) is typically water or a mixture of water and alcohols. The alcohol may be a monohydric, dihydric or polyhydric alcohol having 1-4 carbon atoms, such as methanol, ethanol, n-propanol, isopropanol, ethylene glycol, glycerol, n-butanol, isobutanol or tert-butanol, and preferably methanol and/or ethanol. The solvent is preferably a mixture of water and ethanol. The mass ratio of water/alcohol is within a range of 1-10.

In the method of the present disclosure, the addition and shear treatment of the polymerization inhibitor in step (1) serve to sufficiently break up agglomerates of alumina powder to obtain a stable suspension, wherein the criterion for judging whether the suspension is stable is that the significant (macroscopic) precipitation does not occur after standing still for at least 1 hour under the room temperature and atmospheric pressure conditions. Preferably, the polymerization inhibitor is an organic acid, which may be a monobasic acid, a dibasic acid or a polybasic acid having 1-10 carbon atoms. Preferably, the number of carboxyl is 1-4. In addition to the carboxyl, the organic acid may further comprise one or more hydroxyl groups. Preferably, the organic acid of the present disclosure is one or more selected from the group consisting of formic acid, acetic acid and citric acid. The organic acid is used in an amount of 0.1-10 wt%, preferably 0.5-5 wt%, and more preferably 1-3 wt% of the mass of alumina powder.

In the method of the present disclosure, the shearing conditions in step (1) comprise a rotation speed of 2,000-50,000 rpm and a time of 1-60 min, preferably a rotation speed of 5,000-50,000 rpm and a time of 5-45 min, more preferably 8,000-25,000 rpm and a time of 10-150 min. The shearing temperature is an ambient temperature, i.e. the additional heating or cooling is not required.

In the method of the present disclosure, the crystal plane growth guiding agent is used to induce/control crystal plane growth of alumina grain in order to grow into as many {111} crystal planes as possible. Preferably, the crystal plane growth guiding agent is an organic amine and an organic base. The organic amine may be an amine compound having 1-10 carbon atoms, such as a monoamine, a diamine or a polyamine; one or more selected from the group consisting of a primary amine, a secondary amine and a tertiary amine, and it may be an aliphatic amine or an aromatic amine. In addition to nitrogen (N), the organic amine may comprise one or more hydroxyl groups, i.e., the organic amine may be an alkanolamine. The organic amine of the present disclosure is preferably one or more selected from the group consisting of methylamine, dimethylamine, trimethylamine, ethylamine, diethylamine, N-propylamine, isopropylamine, N-butylamine, ethanolamine, 1,2-propylenediamine, hexamethylenediamine, benzylamine, phenylethylamine.

The organic base may be various tetraalkylammonium hydroxides, the alkyl group may be straight-chain or branched chain alkyl group having 1-5 carbon atoms, such as methyl, ethyl, n-propyl, isopropyl, n-butyl, isobutyl, t-butyl; the four alkyl groups may be same or different, and the organic base is preferably one or more selected from the group consisting of tetramethylammonium hydroxide, tetraethylammonium hydroxide and tetrapropylammonium hydroxide.

Preferably, the crystal plane growth guiding agent is a mixture of an organic amine and an organic base, further preferably the mass ratio of the organic amine to the organic base is preferably 0.1-3:1, preferably 0.5-2:1.

The concentration of the organic amine in the material system is preferably within a range of 10-300g/L, more preferably 15-100g/L, further preferably 18-40g/L; the concentration of the organic base in the material system is preferably 10-300g/L, more preferably 15-100g/L, further preferably 18-40g/L.

In the method of the present disclosure, the conditions of hydrothermal treatment in step (2) comprise a temperature of 60-250°C, preferably 120-280°C, and a time of 2-72 hours, preferably 3-24 hours.

The hydrothermal treatment is preferably carried out in a hermetic autoclave.

In the method of the present disclosure, the drying temperature in step (2) is not more than 200°C, preferably not more than 120°C, and the drying degree is characterized by the constant weight of the material at the drying temperature.

In the method of the present disclosure, the conditions of roasting in step (2) comprise a temperature of 450-750°C, preferably 500-650°C, and a time of 1-24 hours, preferably 3-12 hours.

The alumina grain provided by the present disclosure can be used as the catalyst carriers, or hydrogenation catalyst carrier, or dehydrogenation catalyst carrier. The alumina provided by the present disclosure can provide improved catalytic activity of the catalyst compared to the conventional and commercially available alumina carrier.

For example, the catalyst may be at least one of a hydrodesulfurization catalyst, a hydrogenation demetallization catalyst and a propane dehydrogenation catalyst. The varieties, dosages and preparation methods of the active ingredients of the above catalysts can be selected with reference to the prior art. For example, the active ingredients of the hydrodesulfurization catalyst may be elements W, Mo and Ni and calculated in terms of WO₃, MoO₃ and NiO, and are respectively contained in amounts of 5-10 wt%, 5-10 wt% and 1-5 wt%, based on the total weight of the catalyst. For example, the active metal components of the propane dehydrogenation catalyst are Pt and Sn, and the active components of the hydrogenation demetallization catalyst are Ni and Mo. The present disclosure will not provide unnecessary details in this regard.

The present disclosure will be described in detail with reference to example. The shape and size of alumina grain are observed and measured through a scanning electron microscope. The crystal form is characterized by X-ray diffraction, and the sample particle is determined to be monocrystal or polycrystal through the electron diffraction analysis.

### Example 1

The pseudo-boehmite powder was subjected to roasting at 550°C for 5 hours and uniformly mixed with sodium chloride at an amount of 3% by mass of the pseudo-boehmite, the mixture was subjected to grinding by a ball mill into micro powder, the powder of about 6,000 mesh was sieved, and the sodium chloride was removed by washing with the distilled water, a suspension with a concentration of 22g/L was then prepared by adding a solvent, which was a mixture of water and ethanol in a mass ratio of 4.5. Formic acid was added to the suspension such that the formic acid was used in an amount of 2.0% relative to the mass of an alumina precursor. The suspension was subjected to shearing and stirring by a high-speed shear mixer (with a rotation speed of 20,000 rpm) at room temperature for 20 minutes, the suspension did not present an obvious precipitation after standing still for 1.5 hours under the room temperature and ambient pressure. Ethanolamine and tetraethylammonium hydroxide were added into the system, the concentration of ethanolamine and tetraethylammonium hydroxide in the finally produced system were 25g/L and 20g/L, respectively, and after stirring uniformly, the system was closed and hermetic and then heated to 200°C and subjected to a hydrothermal treatment for 6 hours. The product obtained after drying at 120°C was divided into two parts, which were subjected to drying at 200°C for 6 hours and roasting at 550°C for 6 hours respectively. The XRD spectrum of the products obtained at the two treatment temperatures indicated that the products were pseudo-boehmite and γ-alumina, respectively.

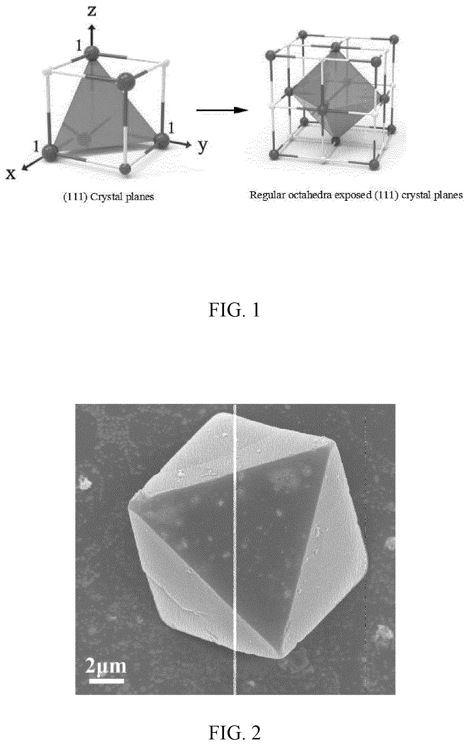

FIG. 2 illustrated a scanning electron microscope photograph of the alumina grain prepared after roasting at 550°C.

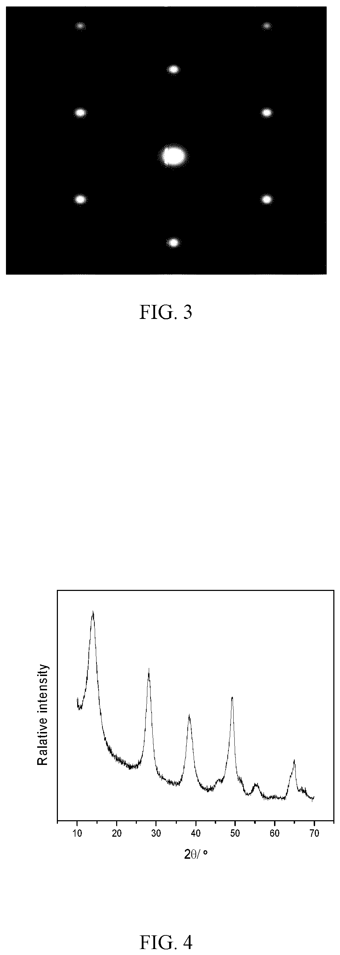

FIG. 3 illustrated an electron diffraction spectrum of the alumina grain product slice prepared after roasting at 550°C.

FIG. 4 illustrated an XRD spectrogram of the alumina grain prepared after drying at 200°C.

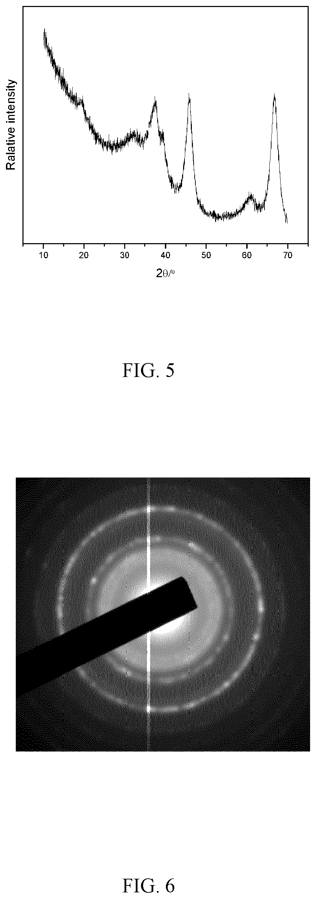

FIG. 5 illustrated an XRD spectrogram of the alumina grain prepared in Example 1 after roasting at 550°C.

As observed by the scanning electron microscope, the drying or roasting temperatures did not impose significant influence on the morphology. Both the dried product and the roasted product had a shape of octahedral particle, the electron diffraction spectra for both the dried product and the roasted product were regularly arranged spots, thus both the dried product and the roasted products had the single-crystal structure. FIG. 2 illustrated the typical electron diffraction spectrum for a roasted product. The octahedral surface exposed the {111} family of crystal planes according to the structural relationship of the cubic crystal system shown in FIG. 1. FIG. 2 illustrated an octahedral grain size of about 17µm, the {111} family of crystal planes of octahedra was approximately equilateral triangle with a side length about 12µm (the relative deviation of the side lengths was about 5.7%), such that an approximate regular octahedra was formed. The percentage of the exposed {111} family of crystal planes of octahedral alumina grain was 100%.

### Example 2

The pseudo-boehmite powder was subjected to roasting at 650°C for 4 hours and uniformly mixed with sodium sulfate at an amount of 5% by mass of the pseudo-boehmite, the mixture was subjected to grinding by a ball mill into micro powder, the powder of about 15,000 mesh was sieved, and the sodium sulfate was removed by washing with the distilled water, a suspension with a mass concentration of 20g/L was then prepared by adding a solvent, which was a mixture of water and methanol in a mass ratio of 1.2. Acetic acid was added to the suspension such that the acetic acid was used in an amount of 3.0% relative to the mass of an alumina precursor. The suspension was subjected to shearing and stirring by a high-speed shear mixer (with a rotation speed of 15,000 rpm) at room temperature for 30 minutes, the suspension did not present an obvious precipitation after standing still for 2 hours under the room temperature and ambient pressure. Triethanolamine and tetramethylammonium hydroxide were added into the system, the concentration of triethanolamine and tetramethylammonium hydroxide in the finally produced system were 23g/L and 36g/L, respectively, and after stirring uniformly, the system was closed and hermetic and then heated to 180°C and subjected to a hydrothermal treatment for 12 hours. The product obtained after drying at 120°C was divided into two parts, which were subjected to drying at 200°C for 6 hours and roasting at 550°C for 6 hours respectively. The XRD spectrum of the products obtained at the two treatment temperatures indicated that the products were pseudo-boehmite and γ-alumina, respectively.

The scanning electron micrograph, electron diffraction micrograph and XRD spectrogram of Example 2 were similar to those of Example 1. Both the dried product and the roasted product had a shape of octahedral particle, the electron diffraction spectra for both the dried product and the roasted product were regularly arranged spots, thus both the dried product and the roasted product had the single-crystal structure. With respect to the roasted product, the octahedral surface exposed the {111} family of crystal planes according to the structural relationship of the cubic crystal system. The scanning electron micrograph illustrated an octahedral grain size of about 15µm, the {111} family of crystal planes of octahedra was approximately equilateral triangle with a side length about 11µm (the relative deviation of the side lengths was about 5.4%), such that an approximate regular octahedra was formed. The percentage of the exposed {111} family of crystal planes of octahedral alumina grain was 100%.

### Example 3

The pseudo-boehmite powder was subjected to roasting at 600°C for 4 hours and uniformly mixed with sodium sulfate at an amount of 3% by mass of the pseudo-boehmite, the mixture was subjected to grinding by a ball mill into micro powder, the powder of about 10,000 mesh was sieved, and the sodium sulfate was removed by washing with the distilled water, a suspension with a mass concentration of 35g/L was then prepared by adding a solvent, which was a mixture of water and methanol in a mass ratio of 2.2. A mixture of formic acid and acetic acid in an equal amount by mass added into the suspension such that the mixed acid was used in an amount of 0.5% relative to the mass of an alumina precursor. The suspension was subjected to shearing and stirring by a high-speed shear mixer (with a rotation speed of 20,000 rpm) at room temperature for 20 minutes, the suspension did not present an obvious precipitation after standing still for 2 hours under the room temperature and atmospheric pressure. Aniline and tetrapropylammonium hydroxide were added into the system, the concentration of aniline and tetrapropylammonium hydroxide in the finally produced system were 30g/L and 25g/L, respectively, and after stirring uniformly, the system was closed and hermetic and then heated to 150°C and subjected to a hydrothermal treatment for 60 hours. The product obtained after drying at 120°C was divided into two parts, which were subjected to drying at 200°C for 6 hours and roasting at 550°C for 6 hours respectively. The XRD spectrum of the products obtained at the two treatment temperatures indicated that the products were pseudo-boehmite and γ-alumina, respectively.

The scanning electron micrograph, electron diffraction micrograph and XRD spectrogram of Example 3 were similar to those of Example 1. Both the dried product and the roasted product had a shape of octahedral particle, the electron diffraction spectra for both the dried product and the roasted product were regularly arranged spots, thus both the dried product and the roasted product had the single-crystal structure. With respect to the roasted product, the octahedral surface exposed the {111} family of crystal planes according to the structural relationship of the cubic crystal system. The scanning electron micrograph illustrated an octahedral grain size of about 49µm, the {111} family of crystal planes of octahedra was approximately equilateral triangle with a side length about 34µm (the relative deviation of the side lengths was about 4.2%), such that an approximate regular octahedra was formed. The percentage of the exposed {111} family of crystal planes of octahedral alumina grain was 100%.

### Example 4

The pseudo-boehmite powder was subjected to roasting at 580°C for 4 hours and uniformly mixed with sodium nitrate at an amount of 4% by mass of the pseudo-boehmite, the mixture was subjected to grinding by a ball mill into micro powder, the powder of about 10,000 mesh was sieved, and the sodium nitrate was removed by washing with the distilled water, an aqueous suspension with a mass concentration of 100g/L was then prepared by adding water, the solvent in the suspension was water. Citric acid was added into the suspension such that the citric acid was used in an amount of 1.5% relative to the mass of an alumina precursor. The suspension was subjected to shearing and stirring by a high-speed shear mixer (with a rotation speed of 10,000 rpm) at room temperature for 150 minutes, the suspension did not present an obvious precipitation after standing still for 1 hour under the room temperature and atmospheric pressure. Benzyl amine and tetraethylammonium hydroxide were added into the system, the concentration of benzyl amine and tetraethylammonium hydroxide in the finally produced system were 46g/L and 16g/L, respectively, and after stirring uniformly, the system was closed and hermetic and then heated to 170°C and subjected to a hydrothermal treatment for 24 hours. The product obtained after drying at 100°C was divided into two parts, which were subjected to drying at 200°C for 4 hours and roasting at 650°C for 4 hours respectively. The XRD spectrum of the products obtained at the two treatment temperatures indicated that the products were pseudo-boehmite and γ-alumina, respectively.

The scanning electron micrograph, electron diffraction micrograph and XRD spectrogram of Example 4 were similar to those of Example 1. Both the dried product and the roasted product had a shape of octahedral particle, the electron diffraction spectra for both the dried product and the roasted product were regularly arranged spots, thus both the dried product and the roasted product had the single-crystal structure. With respect to the roasted product, the octahedral surface exposed the {111} family of crystal planes according to the structural relationship of the cubic crystal system. The scanning electron micrograph illustrated an octahedral grain size of about 86µm, the {111} family of crystal planes of octahedra was approximately equilateral triangle with a side length about 61µm (the relative deviation of the side lengths was about 2.6%), such that an approximate regular octahedra was formed. The percentage of the exposed {111} family of crystal planes of octahedral alumina grain was 100%.

### Example 5

The commercially available alumina powder was uniformly mixed with sodium carbonate at an amount of 3% by mass of the alumina powder, the mixture was subjected to grinding by a ball mill into micro powder, the powder of about 10,000 mesh was sieved, and the sodium carbonate was removed by washing with the distilled water, a suspension with a mass concentration of 15g/L was then prepared by adding a solvent, which was a mixture of water and ethanol in a mass ratio of 3. A portion of acetic acid was added into the suspension such that the acetic acid was used in an amount of 1% relative to the mass of an alumina precursor. The suspension was subjected to shearing and stirring by a high-speed shear mixer (with a rotation speed of 20,000 rpm) at room temperature for 20 minutes, the suspension did not present an obvious precipitation after standing still for 3 hours under the room temperature and atmospheric pressure. Aniline and tetrapropylammonium hydroxide were added into the system, the concentration of aniline and tetrapropylammonium hydroxide in the finally produced system were 23g/L and 40g/L, respectively, and after stirring uniformly, the system was closed and hermetic and then heated to 270°C and subjected to a hydrothermal treatment for 6 hours. The product obtained after drying at 180°C was subsequently subjected to roasting at 500°C for 8 hours.

The scanning electron micrograph, electron diffraction micrograph and XRD spectrogram of Example 5 were similar to those of Example 1. The product had a shape of octahedral particle, the electron diffraction spectra for the roasted product illustrated the regularly arranged diffraction spots, thus the roasted product had the single-crystal structure. With respect to the roasted product, the octahedral surface exposed the {111} family of crystal planes according to the structural relationship of the cubic crystal system. The scanning electron micrograph illustrated an octahedral grain size of about 12µm, the {111} family of crystal planes of octahedra was approximately equilateral triangle with a side length about 8µm (the relative deviation of the side lengths was about 6.7%), such that an approximate regular octahedra was formed. The percentage of the exposed {111} family of crystal planes of octahedral alumina grain was 100%.

### Example 6

The pseudo-boehmite powder was subjected to roasting at 550°C for 5 hours and uniformly mixed with sodium acetate at an amount of 3% by mass of the pseudo-boehmite, the mixture was subjected to grinding by a ball mill into micro powder, the powder of about 6,000 mesh was sieved, and the sodium acetate was removed by washing with the distilled water, a suspension with a mass concentration of 22g/L was then prepared by adding a solvent, which was a mixture of water and ethanol in a mass ratio of 4.5. Formic acid was added into the suspension such that the formic acid was used in an amount of 2.0% relative to the mass of an alumina precursor. The suspension was subjected to shearing and stirring by a high-speed shear mixer (with a rotation speed of 20,000 rpm) at room temperature for 20 minutes, the suspension did not present an obvious precipitation after standing still for 1.5 hours under the room temperature and atmospheric pressure. Ethanolamine and tetraethylammonium hydroxide were added into the system, the concentration of ethanolamine and tetraethylammonium hydroxide in the finally produced system were 25g/L and 20g/L, respectively, and after stirring uniformly, the system was closed and hermetic and then heated to 200°C and subjected to a hydrothermal treatment for 6 hours. The product obtained after drying at 120°C was subjected to roasting at 550°C for 6 hours.

The characterization results of the produced product in Example 6 were similar to those of Example 1, the product was the single-crystal octahedral grain with surface exposed the {111} family of crystal planes. The octahedral grain size was about 26µm, the {111} family of crystal planes of octahedra was approximately equilateral triangle with a side length about 18µm (the relative deviation of the side lengths was about 4.9%), such that an approximate regular octahedra was formed. The percentage of the exposed {111} family of crystal planes of octahedral alumina grain was 100%.

### Example 7

The pseudo-boehmite powder was subjected to roasting at 650°C for 4 hours and uniformly mixed with sodium sulfate at an amount of 5% by mass of the pseudo-boehmite, the mixture was subjected to grinding by a ball mill into micro powder, the powder of about 15,000 mesh was sieved, and the sodium sulfate was removed by washing with the distilled water, a suspension with a mass concentration of 20g/L was then prepared by adding a solvent, which was a mixture of water and methanol in a mass ratio of 1.2. Citric acid was added into the suspension such that the citric acid was used in an amount of 3.0% relative to the mass of an alumina precursor. The suspension was subjected to shearing and stirring by a high-speed shear mixer (with a rotation speed of 15,000 rpm) at room temperature for 30 minutes, the suspension did not present an obvious precipitation after standing still for 2 hours under the room temperature and atmospheric pressure. Triethanolamine and tetramethylammonium hydroxide were added into the system, the concentration of triethanolamine and tetramethylammonium hydroxide in the finally produced system were 23g/L and 36g/L, respectively, and after stirring uniformly, the system was closed and hermetic and then heated to 180°C and subjected to a hydrothermal treatment for 12 hours. The product obtained after drying at 120°C was subjected to roasting at 550°C for 6 hours.

The characterization results of the produced product in Example 7 were similar to those of Example 1, the product was the single-crystal octahedral grain with surface exposed the {111} family of crystal planes. The octahedral grain size was about 10µm, the {111} family of crystal planes of octahedra was approximately equilateral triangle with a side length about 7µm (the relative deviation of the side lengths was about 8.5%), such that an approximate regular octahedra was formed. The percentage of the exposed {111} family of crystal planes of octahedral alumina grain was 100%.

### Example 8

The pseudo-boehmite powder was subjected to roasting at 550°C for 5 hours and uniformly mixed with sodium chloride at an amount of 3% by mass of the pseudo-boehmite, the mixture was subjected to grinding by a ball mill into micro powder, the powder of about 6,000 mesh was sieved, and the sodium chloride was removed by washing with the distilled water, a suspension with a mass concentration of 22g/L was then prepared by adding a solvent, which was a mixture of water and ethanol in a mass ratio of 4.5. Formic acid was added into the suspension such that the formic acid was used in an amount of 2.0% relative to the mass of an alumina precursor. The suspension was subjected to shearing and stirring by a high-speed shear mixer (with a rotation speed of 20,000 rpm) at room temperature for 20 minutes, the suspension did not present an obvious precipitation after standing still for 1.5 hours under the room temperature and atmospheric pressure. Ethanolamine and tetraethylammonium hydroxide were added into the system, the concentration of ethanolamine and tetraethylammonium hydroxide in the finally produced system were 21g/L and 11g/L, respectively.

The characterization results of the produced product in Example 8 were similar to those of Example 1, the product was the single-crystal octahedral grain with surface exposed the {111} family of crystal planes. The octahedral grain size was about 12µm, the {111} family of crystal planes of octahedra was approximately equilateral triangle with a side length about 8µm (the relative deviation of the side lengths was about 6.4%), such that an approximate regular octahedra was formed. The percentage of the exposed {111} family of crystal planes of octahedral alumina grain was nearly 100%.

### Comparative example 1

Alumina was prepared according to the same method as that of Example 1, except that the ethanolamine was replaced by the same weight of tetraethylammonium hydroxide, i.e., an organic amine was not added; when the characterization results of the produced product were compared with those of Example 1, the particle size was about 31µm, but the product did not have a regular morphology, thus the product did not exhibit the determined exposure relationship of the crystal planes on the surface.

### Comparative example 2

Alumina was prepared according to the same method as that of Example 1, except that ethanolamine and tetraethylammonium hydroxide were not added into the system after the high-speed shearing, the system was then directly subjected to a hermetic hydrothermal treatment and subsequent operations; when the characterization results of the produced product were compared with those of Example 1, the product did not have a regular morphology, thus the product did not exhibit the determined exposure relationship of the crystal planes on the surface.

### Comparative example 3

The octahedral alumina grain was prepared according to the method provided in Example 1 of CN201610494090.3. The produced product was subjected to drying at 200°C for 5 hours and roasting at 550°C for 5 hours. The product obtained from roasting at 200°C did not have a pseudo-boehmite or boehmite structure, and the electron diffraction spectrum of the product obtained from roasting at 550°C was shown in FIG. 6. As can be seen from the graphical characteristics of the electron diffraction spectrogram, the product obtained from roasting at 550°C was polycrystalline (ring-shaped electron diffraction spectrum), rather than a single-crystal structure (orderly arranged spot electron diffraction spectrum).

### Comparative example 4

Alumina was prepared according to the same method as that of Example 1, except that the pseudo-boehmite powder was not subjected to grinding, the 200 mesh pseudo-boehmite was directly used and mixed with water to prepare the suspension to carry out the subsequent operations; when the characterization results of the produced product were compared with those of Example 1, the product did not have a regular morphology, thus the product did not exhibit the determined exposure relationship of the crystal planes on the surface.

### Performance testing

### 1) Catalytic performance of the distillate oil hydrodesulfurization catalyst

Preparation of the catalyst: the alumina powder obtained from Examples 1-8 and Comparative examples 1-4 and the pseudo-boehmite powder (after roasting at 550°C for 3 hours) from the Sasol Company were used as the raw materials, the materials were molded into a cylindrical shape with a diameter of 2.5mm, and the molded product was subjected to drying at 120°C for 3 hours and roasting at 550°C for 3 hours to obtain a carrier. The carrier was taken, and separately impregnated with an aqueous solution of a mixture of ammonium metatungstate, ammonium molybdate and nickel nitrate, such that the contents of WO₃, MoO₃, NiO were 8.2%, 7.1% and 2.8%, respectively. The impregnated carrier was subsequently subjected to drying at 120°C for 2 hours and roasting at 550°C for 2 hours to prepare an oxidation state catalyst. Various catalysts were subjected to activity evaluation in a hydrodesulfurization of coked naphtha by using a microreactor under the following reaction conditions: a pressure of 5.0MPa, volumetric hydrogen/oil ratio of 300, volume hourly space velocity of 5.0h⁻¹, a reaction temperature of 280°C and a reaction time of 15 days. The results were shown in Table 1 below.

### 2) Catalytic activity of the propane dehydrogenation catalyst

The alumina powder obtained from Examples 1-8 and Comparative examples 1-4 and the pseudo-boehmite powder (after roasting at 550°C for 3 hours) from the Sasol Company were used as the raw materials, the materials were subjected to ball-rolling molding into spherical particles with a diameter of 2mm, the molded product was subjected to drying at 120°C for 3 hours and roasting at 550°C for 3 hours to obtain a carrier. 0.08g of H₂PtCl₆·6H₂O, 0.21g of SnCl₄·5H₂O, and 0.19g of NaNO₃ were dissolved in 100ml of deionized water, and then stirred sufficiently to form a homogeneous solution. Eight units of the same solutions were mixed with the spherical carrier, respectively, and then stirred at room temperature for 6 hours, and the water in the system was evaporated by a rotary evaporator to obtain a solid product. The solid product was subjected to drying at 120°C for 3 hours, and subsequently roasting at 600°C for 5 hours, and then subjecting to reduction with H₂ to obtain two groups of supported Pt-Sn/A1₂O₃ catalysts. 0.5g of the catalysts was loaded into a fixed bed quartz reactor, the reaction temperature was controlled to be 610°C, the reaction pressure was 0.1MPa, the molar ratio of propane/hydrogen was 1:1, the mass hourly space velocity of propane was 3.0h⁻¹, and the reaction time was 50 hours. The results were shown in Table 1 below.

**Table 1. Catalytic performance of the distillate oil hydrodesulfurization catalyst**

| Source of carriers | Grain size, µm | Side length deviation, % | Desulfurization rate of hydrodesulfurization, % | Propane dehydrogenation | |
|---|---|---|---|---|---|
| | | | | Propane conversion rate, % | Propylene selectivity, % |
| Example 1 | 17 | 5.7 | 99.40 | 27.52 | 99.20 |
| Example 2 | 15 | 5.4 | 99.62 | 28.13 | 99.31 |
| Example 3 | 49 | 4.2 | 95.28 | 25.34 | 97.62 |
| Example 4 | 86 | 2.6 | 93.58 | 23.19 | 95.18 |
| Example 5 | 12 | 6.7 | 99.80 | 28.35 | 99.47 |
| Example 6 | 26 | 4.9 | 97.36 | 26.42 | 98.22 |
| Example 7 | 10 | 8.5 | 99.86 | 29.78 | 99.63 |
| Example 8 | 12 | 6.4 | 99.42 | 27.73 | 99.59 |
| Comparative example 1 | 31 | / | 82.57 | 20.14 | 62.19 |
| Comparative example 2 | 35 | / | 78.18 | 18.56 | 59.62 |
| Comparative example 3 | 18 | 5.9 | 91.52 | 25.47 | 91.34 |
| Comparative example 4 | 35 | / | 80.12 | 18.26 | 58.63 |
| Commercially available Sasol product | 33 | / | 89.57 | 27.28 | 93.1 |

As can be seen from the results in Table 1, when the catalysts produced from the alumina carriers prepared in the present disclosure (Examples 1-8) and Comparative examples 1-4 are compared with the catalyst produced from the commercially available alumina carrier, the catalytic performance of each of the alumina carriers prepared in the Examples 1-8 is superior to that of the alumina carriers in the Comparative examples and the commercially available product in the catalytic reactions of coked naphtha hydrodesulfurization and propane dehydrogenation to produce propylene, respectively.

### 3) Catalytic performance of the residue oil hydrodesulfurization catalyst

The alumina powder obtained from Examples 1-8 and Comparative examples 1-4 and the pseudo-boehmite powder from the Sasol Company were used as the raw materials, the materials were molded into the strip-type carrier, which was subjected to roasting at 900°C for 3 hours. Preparation of the catalysts: the carriers were used, ammonium molybdate, nickel nitrate, phosphoric acid and an organic chelating agent were prepared into a metal salt complex liquid, the carriers were impregnated with the metal salt complex liquid for 2 hours, the carriers were taken out and subjected to drying in the shade, and were subjected to drying at 120°C for 5 hours and roasting at 450°C for 4 hours, such that the oxidation state Ni-Mo/Al₂O₃ residual oil hydrogenation demetallization catalyst was prepared. Catalyst performance evaluation: the mixed residue from Maoming Petrochemical Company was applied as the raw material, the catalyst performance evaluation was performed on a 200mL fixed bed reactor. Both ends of the reactor was filled with silica sand, and 100mL of catalyst was charged in the middle section. The reaction conditions were as follows: after sulfidation of the catalyst, the reaction temperature was 375°C, hydrogen partial pressure was 15MPa, volume ratio of hydrogen/oil was 760, mass hourly space velocity was 5.0h⁻¹, an oil sample was taken and subjected to testing after that the reaction was performed for 300 hours and the activity of the catalyst was stabilized. The test results were shown in Table 2.

Wherein the demetalization rate = (content of metal elements in the raw material - the content of metal elements in the hydrogenated distillate) / content of metal elements in the raw material * 100%. The content of metal elements was measured by inductively coupled plasma (ICP) emission spectrometer method. Desulfurization rate = (content of sulfur element in the raw material - the content of sulfur element in hydrogenated distillate) / content of sulfur element in the raw material *100%. The content of sulfur element was measured by energy chromatic dispersion X-ray fluorescence spectroscopy.

**Table 2. Performance testing of the residue oil hydrogenation demetallization catalyst**

| Sources of carriers | Grain size, µm | Side length deviation, % | demetalization rate, % | desulfurization rate, % |
|---|---|---|---|---|
| Example 1 | 17 | 5.7 | 62.52 | 46.70 |
| Example 2 | 15 | 5.4 | 62.71 | 47.12 |
| Example 3 | 49 | 4.2 | 61.45 | 44.90 |
| Example 4 | 86 | 2.6 | 60.52 | 41.75 |
| Example 5 | 12 | 6.7 | 63.36 | 48.68 |
| Example 6 | 26 | 4.9 | 62.38 | 46.59 |
| Example 7 | 10 | 8.5 | 65.28 | 49.56 |
| Example 8 | 12 | 6.4 | 63.40 | 48.75 |
| Comparative example 1 | 31 | / | 58.25 | 40.39 |
| Comparative example 2 | 35 | / | 52.54 | 38.35 |
| Comparative example 3 | 18 | 5.5 | 52.15 | 37.56 |
| Comparative example 4 | 35 | / | 57.43 | 41.53 |
| Commercially available Sasol product | 33 | / | 55.17 | 36.21 |

As can be seen from the results in Table 2, when the catalysts produced from the alumina carriers prepared in the present disclosure (Examples 1-8) and Comparative examples 1-4 are compared with the catalyst produced from the commercially available alumina carrier, the demetallization rate of each of the alumina carriers prepared in the Examples is superior to that of the alumina carriers in the Comparative examples and the commercially available product in the residue oil hydrogenation and demetallization reaction, and the alumina carriers prepared in the Examples have higher desulfurization rate.

## Claims

1. An alumina grain, wherein the alumina grain has a single-crystal structure and an approximate regular octahedral stereoscopic morphology; eight sides of the alumina grain belong to the {111} family of crystal planes of γ-state alumina, and the alumina grain has a grain size within a range of 5-100µm, wherein approximate regular octahedra refers to that each of the eight crystal planes on the octahedral surfaces forms a triangle, and the side lengths of the eight triangles are approximately equal, and the relative deviation of any side length of any one of the triangles as compared to an average of the total side lengths of the eight triangles falls into the range of ±10%, and the size of alumina grain are observed and measured through a scanning electron microscope.

2. The alumina grain of claim 1, wherein the eight crystal planes have a side length of 5-50µm.

3. The alumina grain of claim 1 or 2, wherein the alumina grain has a grain size of 10-80µm.

4. The alumina grain of any one of claims 1 to 3, wherein the alumina grain has an X-Ray Diffraction (XRD) spectrogram comprising peaks adjacent to positions of 33.53°, 36.82°, 39.49°, 46.38°, 60.89° and 67.01° when the angle 2θ=10-70°.

5. A preparation method of alumina grain of any one of claims 1-4 comprising the following steps:
(1) subjecting an alumina powder having a particle size not exceeding 1,000 mesh to a shear treatment in the presence of a solvent and a polymerization inhibitor to obtain a stable suspension;
(2) mixing the suspension obtained in step (1) with a crystal plane growth guiding agent uniformly and subjecting the mixture to a hydrothermal treatment under a hermetic conditions, then performing a solid-liquid separation, and subjecting the solid to drying and roasting.

6. The preparation method of claim 5, wherein the polymerization inhibitor is an organic acid, preferably one or more selected from the group consisting of formic acid, acetic acid and citric acid;
preferably, the organic acid is used in an amount of 0.1-10 wt%, preferably 0.5-5 wt%, more preferably 1-3 wt% based on the mass of alumina powder.

7. The preparation method of claim 5 or 6, wherein the solvent is water or a mixture of water and alcohol; the alcohol is preferably one or more selected from the group consisting of methanol, ethanol, n-propanol, isopropanol, ethylene glycol, glycerol, n-butanol, isobutanol, tert-butanol; preferably, the solvent is a mixture of water and ethanol, and the mass ratio of water/alcohol is within a range of 1-5.

8. The preparation method of claim 5 or 6 or 7, wherein the crystal plane growth guiding agent is an organic amine and an organic base, a mass ratio of the organic amine to the organic base is preferably within a range of 0.1-3:1, more preferably 0.5-2:1.

9. The preparation method of claim 8, wherein the concentration of the organic amine is within a range of 10-300g/L, more preferably 15-100g/L, further preferably 18-40g/L; the concentration of the organic base in the material system is preferably within a range of 10-300g/L, more preferably 15-100g/L, further preferably 18-40g/L.

10. The preparation method of claim 8 or 9, wherein the organic amine is one or more selected from the group consisting of methylamine, dimethylamine, trimethylamine, ethylamine, diethylamine, n-propylamine, isopropylamine, n-butylamine, ethanolamine, 1,2-propyldiamine, hexamethylenediamine, benzylamine, phenethylamine; and the organic base is one or more selected from the group consisting of tetramethylammonium hydroxide, tetraethylammonium hydroxide, tetrapropylammonium hydroxide.

11. The preparation method of any of claims 5 to 10, wherein the conditions for hydrothermal treatment comprise: a temperature of 60-250°C, preferably 120-280°C, and a time of 2-72 hours, preferably 3-8 hours.

12. The preparation method of any of claims 5 to 11, wherein the conditions of roasting comprise a temperature of 450-750°C, preferably 500-650°C, and a time of 1-24 hours, preferably 3-12 hours.

13. Use of alumina grain of any one of claims 1-4 as a catalyst carrier.

14. The use of claim 13, wherein the catalyst is at least one of a hydrodesulfurization catalyst, a hydrogenation demetallization catalyst
and a propane dehydrogenation catalyst.

## Patentansprüche

1. Aluminiumoxidkorn, wobei das Aluminiumoxidkorn eine Einkristallstruktur und eine annähernd regelmäßige oktaedrische stereoskopische Morphologie aufweist; acht Seiten des Aluminiumoxidkorns zur {111}-Familie der Kristallebenen von γ-Zustands-Aluminiumoxid gehören, und das Aluminiumoxidkorn eine Korngröße im Bereich von 5-100 µm aufweist, wobei sich annähernd regelmäßige Oktaeder darauf bezieht, dass jede der acht Kristallebenen auf den oktaedrischen Oberflächen ein Dreieck bildet und die Seitenlängen der acht Dreiecke annähernd gleich sind und die relative Abweichung einer beliebigen Seitenlänge eines beliebigen Dreiecks im Vergleich zu einem Mittel der gesamten Seitenlängen der acht Dreiecke in den Bereich von ±10 % fällt, und die Größe des Aluminiumoxidkorns durch ein Rasterelektronenmikroskop beobachtet und gemessen wird.

2. Aluminiumoxidkorn gemäß Anspruch 1, wobei die acht Kristallebenen eine Seitenlänge von 5-50 µm aufweisen.

3. Aluminiumoxidkorn gemäß Anspruch 1 oder 2, wobei das Aluminiumoxidkorn eine Korngröße von 10-80 µm aufweist.

4. Aluminiumoxidkorn gemäß mindestens einem der Ansprüche 1 bis 3, wobei das Aluminiumoxidkorn ein Röntgendiffraktogramm (XRD) aufweist, umfassend Peaks angrenzend an Positionen von 33,53°, 36,82°, 39,49°, 46,38°, 60,89° und 67,01°, wenn der Winkel 2θ = 10-70° beträgt.

5. Verfahren zur Herstellung eines Aluminiumoxidkorns gemäß mindestens einem der Ansprüche 1 bis 4, umfassend die folgenden Schritte:
(1) Unterziehen eines Aluminiumoxidpulvers mit einer Teilchengröße von nicht mehr als 1000 Mesh einer Scherbehandlung in Gegenwart eines Lösungsmittels und eines Polymerisationsinhibitors, um eine stabile Suspension zu erhalten;
(2) gleichmäßiges Mischen der in Schritt (1) erhaltenen Suspension mit einem Kristallebenenwachstumsleitmittel und Unterziehen der Mischung einer hydrothermalen Behandlung unter hermetischen Bedingungen, anschließendes Durchführen einer Fest-Flüssig-Trennung und Unterziehen des Feststoffs einer Trocknung und Rösten.

6. Herstellungsverfahren gemäß Anspruch 5, wobei der Polymerisationsinhibitor eine organische Säure ist, vorzugsweise eine oder mehrere ausgewählt aus der Gruppe bestehend aus Ameisensäure, Essigsäure und Zitronensäure; wobei vorzugsweise die organische Säure in einer Menge von 0,1-10 Gew.-%, vorzugsweise 0,5-5 Gew.-%, noch bevorzugter 1-3 Gew.-%, bezogen auf die Masse des Aluminiumoxidpulvers, verwendet wird.

7. Herstellungsverfahren gemäß Anspruch 5 oder 6, wobei das Lösungsmittel Wasser oder eine Mischung aus Wasser und Alkohol ist; der Alkohol vorzugsweise einer oder mehrere ausgewählt aus der Gruppe bestehend aus Methanol, Ethanol, n-Propanol, Isopropanol, Ethylenglykol, Glycerin, n-Butanol, Isobutanol, tert-Butanol ist;
wobei vorzugsweise das Lösungsmittel eine Mischung aus Wasser und Ethanol ist, und das Massenverhältnis von Wasser/Alkohol in einem Bereich von 1-5 liegt.

8. Herstellungsverfahren gemäß Anspruch 5 oder 6 oder 7, wobei das Kristallebenenwachstumsleitmittel ein organisches Amin und eine organische Base ist, wobei das Massenverhältnis des organischen Amins zur organischen Base vorzugsweise im Bereich von 0,1-3:1, noch bevorzugter 0,5-2:1 liegt.

9. Herstellungsverfahren gemäß Anspruch 8, wobei die Konzentration des organischen Amins in einem Bereich von 10-300 g/l, vorzugsweise 15-100 g/l, noch bevorzugter 18-40 g/l liegt; die Konzentration der organischen Base in dem Materialsystem vorzugsweise in einem Bereich von 10-300 g/l, noch bevorzugter 15-100 g/l, weiter bevorzugt 18-40 g/l liegt.

10. Herstellungsverfahren gemäß Anspruch 8 oder 9, wobei das organische Amin eines oder mehrere ist, das ausgewählt ist aus der Gruppe bestehend aus Methylamin, Dimethylamin, Trimethylamin, Ethylamin, Diethylamin, n-Propylamin, Isopropylamin, n-Butylamin, Ethanolamin, 1,2-Propylendiamin, Hexamethylendiamin, Benzylamin, Phenethylamin; und die organische Base eine oder mehrere ist, die ausgewählt ist aus der Gruppe bestehend aus Tetramethylammoniumhydroxid, Tetraethylammoniumhydroxid, Tetrapropylammoniumhydroxid.

11. Verfahren zur Herstellung gemäß mindestens einem der Ansprüche 5 bis 10, wobei die Bedingungen für die hydrothermale Behandlung eine Temperatur von 60-250 °C, vorzugsweise 120-280 °C, und eine Zeit von 2-72 Stunden, vorzugsweise 3-8 Stunden, umfassen.

12. Verfahren zur Herstellung gemäß mindestens einem der Ansprüche 5 bis 11, wobei die Bedingungen für das Rösten eine Temperatur von 450-750 °C, vorzugsweise 500-650 °C, und eine Zeit von 1-24 Stunden, vorzugsweise 3-12 Stunden, umfassen.

13. Verwendung eines Aluminiumoxidkorns gemäß mindestens einem der Ansprüche 1 bis 4 als Katalysatorträger.

14. Verwendung gemäß Anspruch 13, wobei der Katalysator mindestens einer ist aus einem
Hydrodesulfurierungskatalysator, einem Hydrierungs-Demetallisierungskatalysator und einem Propan-Dehydrierungskatalysator.

## Revendications

1. Grain d'alumine, dans lequel le grain d'alumine présente une structure monocristalline et une morphologie stéréoscopique octaédrique régulière approximative ; les huit faces du grain d'alumine appartiennent à la famille {111} de plans cristallins de l'alumine γ, et le grain d'alumine présente une taille de grain dans une plage de 5 à 100 µm, dans lequel l'octaèdre régulier approximatif s'entend en ce que chacun des huit plans cristallins sur les surfaces octaédriques forme un triangle, et les longueurs de côté des huit triangles sont approximativement égales, et l'écart relatif de toute longueur de côté de l'un quelconque des triangles par rapport à une moyenne des longueurs de côté totales des huit triangles tombe dans la plage de ±10 %, et la taille du grain d'alumine est observée et mesurée au moyen d'un microscope électronique à balayage.

2. Grain d'alumine selon la revendication 1, dans lequel les huit plans cristallins présentent une longueur de côté de 5 à 50 µm.

3. Grain d'alumine selon la revendication 1 ou la revendication 2, dans lequel le grain d'alumine présente une taille de grain de 10 à 80 µm.

4. Grain d'alumine selon l'une quelconque des revendications 1 à 3, dans lequel le grain d'alumine présente un spectrogramme de diffraction des rayons X (DRX) comprenant des pics adjacents aux positions de 33,53°, 36,82°, 39,49°, 46,38°, 60,89° et 67,01 ° lorsque l'angle 2θ = 10-70°.

5. Procédé de préparation de grain d'alumine selon l'une quelconque des revendications 1 à 4 comprenant les étapes suivantes consistant à :
(1) soumettre une poudre d'alumine présentant une taille de particule n'excédant pas 1 000 mesh à un traitement de cisaillement en présence d'un solvant et d'un inhibiteur de polymérisation pour obtenir une suspension stable ;
(2) mélanger uniformément la suspension obtenue à l'étape (1) avec un agent de guidage de croissance de plan cristallin et soumettre le mélange à un traitement hydrothermique dans des conditions hermétiques, puis mettre en œuvre une séparation solide-liquide, et soumettre le solide à un séchage et à une calcination.

6. Procédé de préparation selon la revendication 5, dans lequel l'inhibiteur de polymérisation est un acide organique, préférablement un ou plusieurs sélectionnés dans le groupe consistant en acide formique, acide acétique et acide citrique ;
préférablement, l'acide organique est utilisé en une quantité de 0,1 à 10 % en masse, préférablement de 0,5 à 5 % en masse, plus préférablement de 1 à 3 % en masse, sur la base de la masse de la poudre d'alumine.

7. Procédé de préparation selon la revendication 5 ou la revendication 6, dans lequel le solvant est de l'eau ou un mélange d'eau et d'alcool ; l'alcool est préférablement un ou plusieurs sélectionnés dans le groupe consistant en méthanol, éthanol, le n-propanol, isopropanol, éthylène glycol, glycérol, n-butanol, isobutanol, tert-butanol ; préférablement, le solvant est un mélange d'eau et d'éthanol, et le rapport massique d'eau/alcool est dans une plage de 1 à 5.

8. Procédé de préparation selon la revendication 5 ou la revendication 6 ou la revendication 7, dans lequel l'agent de guidage de croissance de plan cristallin est une amine organique et une base organique, un rapport massique de l'amine organique sur la base organique est préférablement dans une plage de 0,1-3:1, plus préférablement de 0,5-2:1.

9. Procédé de préparation selon la revendication 8, dans lequel la concentration de l'amine organique est dans une plage de 10 à 300 g/L, plus préférablement de 15 à 100 g/L, de façon encore préférée de 18 à 40 g/L ; la concentration de la base organique dans le système matière est préférablement dans une plage de 10 à 300 g/L, plus préférablement de 15 à 100 g/L, de façon encore préférée de 18 à 40 g/L.

10. Procédé de préparation selon la revendication 8 ou la revendication 9, dans lequel l'amine organique est un ou plusieurs sélectionnés dans le groupe consistant en méthylamine, diméthylamine, triméthylamine, éthylamine, diéthylamine, n-propylamine, isopropylamine, n-butylamine, éthanolamine, 1,2-propyldiamine, hexaméthylènediamine, benzylamine, phénéthylamine ;
et la base organique est un ou plusieurs sélectionnés dans le groupe consistant en hydroxyde de tétraméthylammonium, hydroxyde de tétraéthylammonium, hydroxyde de tétrapropylammonium.

11. Procédé de préparation selon l'une quelconque des revendications 5 à 10, dans lequel les conditions de traitement hydrothermique comprennent : une température de 60 à 250 °C, préférablement de 120 à 280 °C, et une durée de 2 à 72 heures, préférablement de 3 à 8 heures.

12. Procédé de préparation selon l'une quelconque des revendications 5 à 11, dans lequel les conditions de calcination comprennent une température de 450 à 750 °C, préférablement de 500 à 650 °C, et une durée de 1 à 24 heures, préférablement de 3 à 12 heures.

13. Utilisation de grain d'alumine selon l'une quelconque des revendications 1 à 4 en tant que support de catalyseur.

14. Utilisation selon la revendication 13, dans laquelle le catalyseur est au moins un parmi un catalyseur d'hydrodésulfuration, un catalyseur de démétallisation par hydrogénation et un catalyseur de déshydrogénation au propane.
